Europäisches Patentamt

European Patent Office

Office européen des brevets

(11) Publication number: **0 495 282 A2**

# EUROPEAN PATENT APPLICATION

(21) Application number: **91302210.9**

(22) Date of filing: **14.03.91**

(51) Int. Cl.5: **H01L 23/498**

(30) Priority: **17.01.91 JP 3524/91**

(43) Date of publication of application:
**22.07.92 Bulletin 92/30**

(84) Designated Contracting States:
**DE FR GB NL**

(71) Applicant: **SHARP KABUSHIKI KAISHA**
**22-22 Nagaike-cho Abeno-ku**
**Osaka 545(JP)**

(72) Inventor: **Nakanishi, Hiroyuki**
**2613-1, Ichinomoto-cho**
**Tenri-shi, Nara-ken(JP)**
Inventor: **Chikawa, Yasunori**
**4-1-8-15 Umami-Minami, Koryo-cho**
**Kita-Katsuragi-gun, Nara-ken(JP)**

Inventor: **Tajima, Naoyuki**
**54-402, 3-1, Kataokadai, Kanmaki-cho**
**Kita-Katsuragi-gun, Nara-ken(JP)**
Inventor: **Honda, Yoshiaki**
**577-1, Otogi-cho**
**Tenri-shi, Nara-ken(JP)**
Inventor: **Tsuda, Takaaki**
**618 Nishi-Nagara-cho**
**Tenri-shi, Nara-ken(JP)**
Inventor: **Maeda, Takamichi**
**72-4, Izumihara-cho**
**Yamato-Koriyama-shi, Nara-ken(JP)**

(74) Representative: **Brown, Kenneth Richard et al**
**R.G.C. Jenkins & Co. 26 Caxton Street**
**London SW1H 0RJ(GB)**

(54) Film carrier tape for TAB.

(57) A film carrier tape for TAB has a wiring area having a wiring pattern connected to a semiconductor chip to be mounted, and perforation areas having sprocket holes and reinforcement patterns. The sprocket holes are disposed on both sides of the wiring area and arranged along the lengthwise direction of the tape. The reinforcement patterns are formed by the same wiring material as that of the wiring pattern, for reinforcing the sprocket holes.

Fig. 1

## BACKGROUND OF THE INVENTION

### 1. Field of the Invention

The present invention relates to a film carrier tape for TAB (Tape-Automated Bonding).

### 2. Description of the Related Art

A film carrier tape for TAB has perforation areas provided with perforations for carrying the tape, on both the side portions thereof, and a wiring area disposed between the both perforation areas.

The wiring area has a wiring pattern formed by laminating a copper film layer on a base film of polyimide resin or the like, and then by etching the laminated copper film layer. IC (Integrated Circuit) chips, LSI (Large Scale Integrated circuit) chips, or the like are mounted on the tape and connected to the wiring pattern.

The perforations are used to carry the tape in its production process and until TAB semiconductor devices are completely produced. On such the conventional film carrier tape, the perforation areas are not provided with a copper film layer. A large number of sprocket holes disposed in predetermined intervals and size are provided on the base film so as to form the perforations. In other words, on the conventional film carrier tape, a copper film layer, which is a wiring material, is laminated only in the wiring area rather than in the perforation areas and the sprocket holes are directly disposed on the base film.

Thus, with respect to the conventional film carrier tape, the mechanical strength of the perforations is weak. Thereby, when the tape is carried in the production process, the holes are deformed and/or broken. If the perforations are broken, the film cannot be carried causing the production of the TAB semiconductor devices to prevent.

## SUMMARY OF THE INVENTION

Therefore, an object of the present invention is to provide a film carrier tape for TAB, in which the mechanical strength of perforations thereof is high.

According to the present invention, the object of the present invention can be accomplished by a film carrier tape for TAB including a wiring area having a wiring pattern connected to a semiconductor chip to be mounted, and perforation areas having sprocket holes and reinforcement patterns. The sprocket holes are disposed on both sides of the wiring area and arranged along the lengthwise direction of the tape. The reinforcement patterns are formed by the same wiring material as that of the wiring pattern, for reinforcing the sprocket holes.

Since the film carrier tape for TAB has the hole reinforcement patterns on the perforation areas, the mechanical strength of the sprocket holes is secured and thereby the reliability of the carriage of the film carrier tape is improved. In addition, since the reinforcement patterns are formed by the same wiring material as the wiring pattern, these reinforcement patterns can be formed in the same process as that of the wiring pattern. Thus, the number of production processes is not disadvantageously increased.

The above mentioned reinforcement patterns may be formed on the entire perforation areas.

The above mentioned reinforcement patterns may be isolatedly formed in the vicinity of each sprocket hole of the perforation areas.

Further objects and advantages of the present invention will be apparent from the following description of the preferred embodiments of the invention as illustrated in the accompanying drawings.

## BRIEF DESCRIPTION OF THE DRAWINGS

Fig. 1 schematically shows a partial construction of a preferable embodiment of a film carrier tape according to the present invention;

Fig. 2 shows a sectional view along line A-A of the film carrier of the embodiment shown in Fig. 1;

Fig. 3 shows a sectional view of the film carrier of the embodiment shown in Fig. 1, in which the reinforcement patterns of the film carrier are bent;

Fig. 4 schematically shows a partial construction of another embodiment according to the present invention;

Fig. 5 shows a sectional view along line B-B of the film carrier of the embodiment shown in Fig. 4; and

Fig. 6 shows a sectional view of the film carrier of the embodiment shown in Fig. 4, in which the reinforcement patterns of the film carrier are bent.

## DESCRIPTION OF THE PREFERRED EMBODIMENTS

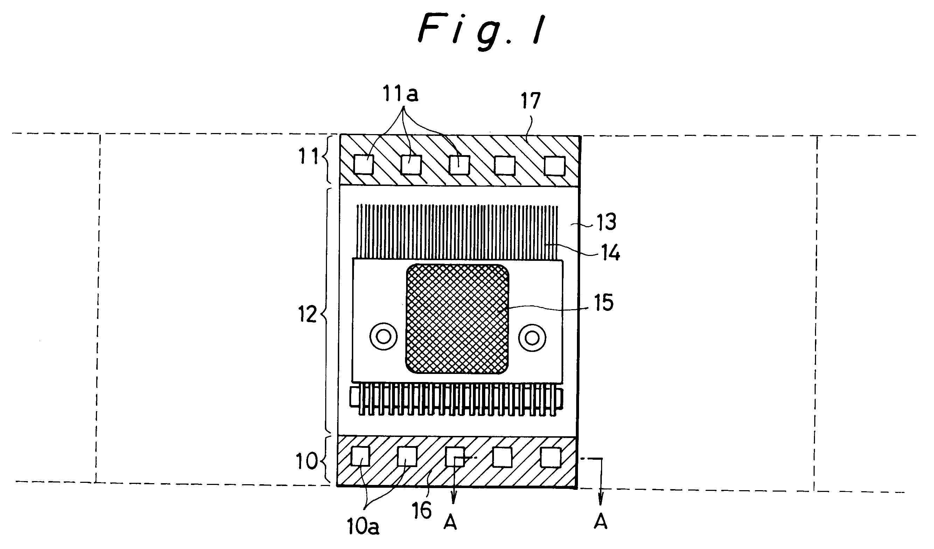

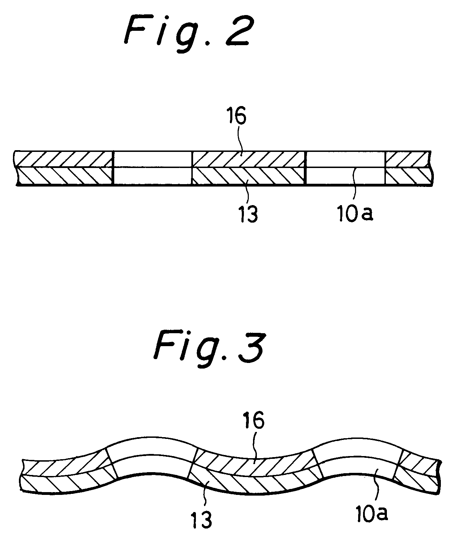

Fig. 1 plainly shows, as a preferable embodiment of a film carrier tape for TAB according to the present invention, a part of the film carrier tape. Semiconductor chip have been just mounted on the film carrier tape. Fig. 2 shows a sectional view along line A-A of the film carrier of this embodiment. Fig. 3 shows a sectional view along line A-A of the film carrier which has been bent. Although Fig. 1 shows a film carrier in accordance with one IC chip, actually a tape is formed with the same film carriers successively connected as shown by the dashed line of the figure.

As shown in Fig. 1, on both the side portions on the front surface of the film carrier tape, perforation areas 10 and 11 are disposed. The perforation areas 10 and 11 are provided with perforations 10a and 11a used for carrying the tape, respectively. The perforations 10a and 11a are made of a plurality of sprocket holes arranged along the lengthwise direction of the tape.

A wiring area 12 is disposed between the perforation areas 10 and 11 on the film carrier tape. The wiring area 12 has a wiring pattern 14 composed of a copper layer laminated on a base film 13 which is made of polyimide resin or the like. At a center portion of the wiring area 12, device holes (not shown in the figure) are provided so as to dispose semiconductor chips 15 such as IC chips, LSI chips, or the like. The semiconductor chips 15 are mounted on and electrically connected to the wiring pattern 14.

The copper layer made of the same material as the wiring pattern 14 also covers the perforation area 10 and 11 on the base film 13 and a large number of sprocket holes arranged in predetermined intervals and size along the lengthwise direction of the tape are formed in the perforation areas 10 and 11. Thus, as shown in Fig. 2, the perforations 10a (and 11a) with a reinforcement pattern 16 (and 17) are formed. In this embodiment, the reinforcement patterns 16 and 17 are formed in the same process as that of the wiring pattern 14.

The film carrier tape of this embodiment is constructed with two layers. Such the film carrier tape is formed in the following manner. First, a thin metal layer of chromium, nickel, or the like is formed on the polyimide film 13 by the spattering method or the electroless plating method. Thereafter, both the front and rear surfaces of the polyimide film 13 are coated with a photoresist. The photoresist on the front surface of the polyimide film 13 is exposed with a pattern for forming copper layers of the wiring pattern 14 and the reinforcement patterns 16 and 17. The photoresist on the rear surface of the polyimide film 13 is exposed with a pattern for making holes of the perforations 10a and 11a, device holes, and so forth. Thereafter, on the front surface of the polyimide film 13, the portion where the photoresist is removed is electrolytically plated and thereby both the copper layers of the wiring pattern 14 and the reinforcement patterns 16 and 17 are formed. On the rear surface of the polyimide film 13, the portion where the photoresist is removed is etched and thereby the holes of the perforations 10a and 11a, the device holes, and so forth are made through the polyimide film 13. In the above-mentioned process, the reinforcement patterns 16 and 17 are formed in the same process as that of the wiring pattern 14.

The film carrier tape can be constructed with three layers. In this case, the polyimide film and the copper film are laminated with epoxy bonding agent so as to form a laminate of the copper layer and the polyimide layer. Then, the perforations 10a and 11a, the device holes, and so forth are punched. Thereafter, the copper layer is etched to form then the wiring pattern 14 and the reinforcement patterns 16 and 17. In the above-mentioned process, the reinforcement patterns 16 and 17 are also formed in the same process as that of the wiring pattern 14.

The three-layered film carrier tape may be also formed in the following manner. A copper film and a polyimide film on which the perforations 10a and 11a, the device holes, and so forth have been made are laminated through epoxy bonding agent. Thereafter, a copper layer is etched on the laminate and then the wiring pattern 14 and the reinforcement patterns 16 and 17 are formed. In this method, the reinforcement patterns 16 and 17 are also formed in the same process as that of the wiring pattern 14.

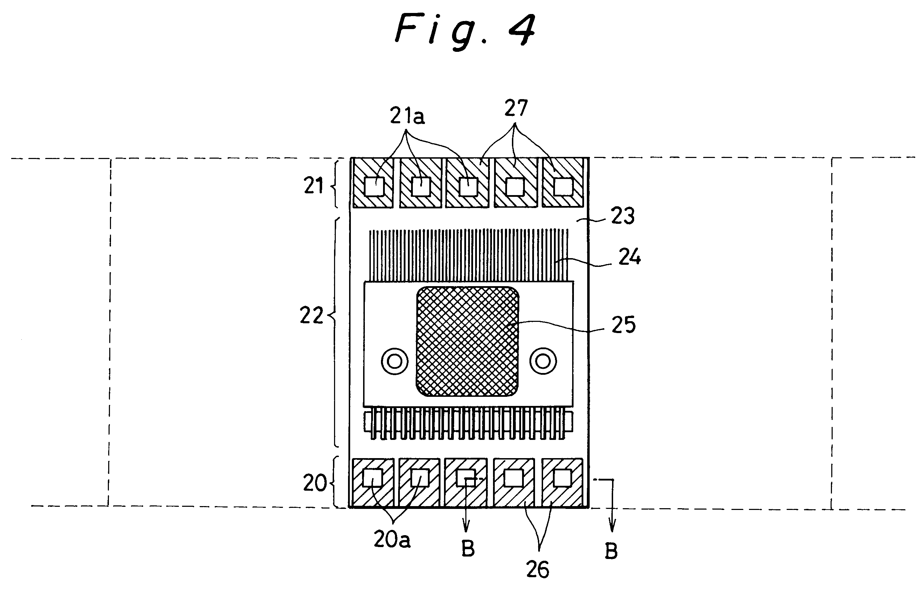

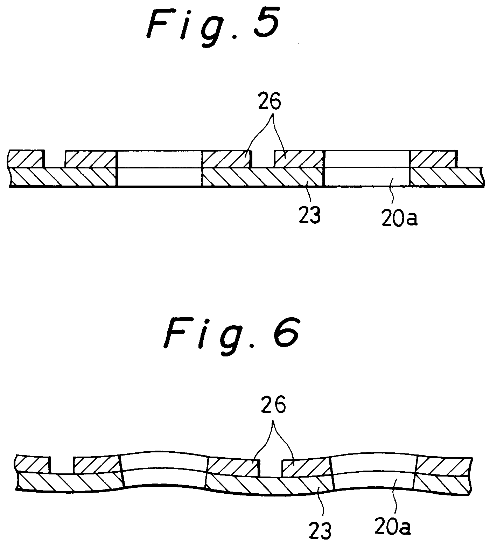

Fig. 4 plainly shows, as another embodiment of a film carrier tape for TAB according to the present invention, a part of the film carrier tape. Semiconductor chips have been just mounted on the film carrier tape. Fig. 5 shows a sectional view along line B-B of the film carrier of the embodiment. Fig. 6 shows a sectional view along line B-B of the film carrier which is bent. Like Fig. 1, although Fig. 4 shows a film carrier in accordance with one IC chip, actually a tape is formed with the same film carriers successively connected as shown by the dashed line of the figure.

As shown in Fig. 4, on both the side portions on the front surface of the film carrier tape, perforation areas 20 and 21 with respective perforations 20a and 21a used for carrying the tape are disposed. The perforation areas 20 and 21 are provided with perforations 20a and 21a for carrying the tape, respectively. The perforations 20a and 21a are made of a plurality of sprocket holes arranged along the lengthwise direction of the tape.

A wiring area 22 is disposed between the perforation areas 20 and 21 on the film carrier tape. The wiring area 22 has a wiring pattern 24 composed of a copper layer laminated on a base film 23 which is made of polyimide resin or the like. At a center portion of the wiring area 22, device holes (not shown in the figure) are provided so as to dispose semiconductor chips 25 such as IC chips, LSI chips, or the like. The semiconductor chips 25 are mounted on and electrically connected to the wiring pattern 24.

The copper layer made of the same material as the wiring pattern 24 also covers the perforation area 20 and 21 on the base film 23 and a large number of sprocket holes arranged in predetermined intervals and size along the lengthwise direction of the tape are formed in the perforation areas 20 and 21. Thus, as shown in Fig. 5, the perforations 20a (and 21a) with a reinforcement pattern 26 (and 27) are formed. In this embodiment, each part of the reinforcement patterns 26 and 27 is formed around the holes of the perforations 20a and 21a as an isolated island. These reinforcement patterns 26 and 27 are also formed in the same process as that of the wiring pattern 24.

The film carrier tape of this embodiment is constructed with two layers. Such the film carrier tape is formed in the following manner. First, a thin metal layer of chromium, nickel, or the like is formed on the polyimide film 23 by the spattering method or the electroless plating method. Thereafter, both the front and rear surfaces of the polyimide film 23 are coated with a photoresist. The photoresist on the front surface of the polyimide film 23 is exposed with a pattern for forming copper layers of the wiring pattern 24 and the reinforcement patterns 26 and 27. The photoresist on the rear surface of the polyimide film 23 is exposed with a pattern for making holes of the perforations 20a and 21a, device holes, and so forth. Thereafter, on the front surface of the polyimide film 23, the portion where the photoresist is removed is electrolytically plated and thereby the copper layers of the wiring pattern 24 and the reinforcement patterns 26 and 27 are formed. On the rear surface of the polyimide film 23, the portion where the photoresist is removed is etched and thereby the holes of the perforations 20a and 21a, the device holes, and so forth are made on the polyimide film 23. In the above mentioned process, the reinforcement patterns 26 and 27 are formed in the same process as that of the wiring pattern 24.

When the aforementioned reinforcement patterns are formed on the film carrier tape, the tape may be mostly skewed and thereby bent. However, as shown in Figs. 3 and 6, when isolated patterns 26 and 27 are formed in the vicinity of each of the sprocket holes 20a and 21a, the degree of the bending is lesser than that of the embodiment shown in Fig. 1, where the reinforcement patterns are formed in the entire perforation areas.

Even in this embodiment, the film carrier tape can be constructed with two or three layers in the aforementioned various manners.

As the base films 13 and 23, glass epoxy, BT resin, or polyester film can be used besides the aforementioned polyimide.

Moreover, besides the two-layered construction or three-layered construction, the present invention can be applied to the film carrier tapes with four-layered or more multi-layered construction.

Many widely different embodiments of the present invention may be constructed without departing from the spirit and scope of the present invention. It should be understood that the present invention is not limited to the specific embodiments described in the specification, except as defined in the appended claims.

There are described above novel features which the skill man will appreciate give rise to advantages. These are each independent aspects of the invention to he covered by the present application, irrespective of whether or not they are included within the scope of the following claims.

**Claims**

1. A film carrier tape, comprising:
   a wiring area having a wiring pattern to be connected to a semiconductor chip being mounted; and
   perforation areas having sprocket holes disposed on both sides of said wiring area and arranged along the lengthwise direction of said tape, and reinforcement patterns formed by the same wiring material as that of said wiring pattern, for reinforcing said sprocket holes.

2. A film carrier tape as claimed in claim 1, wherein said reinforcement patterns are formed entirely on said perforation areas.

3. A film carrier tape as claimed in claim 1, wherein said reinforcement patterns are formed isolatedly in the vicinity of each sprocket hole of said perforation areas.

4. A film carrier tape as claimed in claim 1, wherein said wiring pattern and said reinforcement patterns are formed with copper layers.

5. A film carrier tape as claimed in claim 1, wherein said wiring pattern area and said reinforcement pattern areas are constructed with two layers.

6. A film carrier tape as claimed in claim 5, wherein said wiring pattern area and said reinforcement pattern areas are piled with copper layers and resin layers.

7. A film carrier tape as claimed in claim 6, wherein said resin layers are made of polyimide resign.

8. A film carrier tape as claimed in claim 1, wherein said wiring area and said perforation areas are constructed with three layers.

9. A film carrier tape as claimed in claim 8, wherein said wiring area and the perforation areas are laminated with a copper layer, a bonding layer, and a resin layer.

10. A film carrier tape as claimed in claim 9, wherein said resin layer is made of polyimide resin.

11. A carrier tape for mounting semiconductor chips (15) in an elongate area (12) extending along said tape, said tape having wiring patterns (14) for said semiconductor chips, formed in said elongate area, and sprocket holes (10a, 11a) spaced regularly along said tape, characterized in that said sprocket holes are reinforced by a reinforcement pattern (16, 17) comprising the same material as that of said wiring pattern.

# Fig. 1

EP 0 495 282 A2

Fig. 2

Fig. 3

# Fig. 4

EP 0 495 282 A2

# Fig. 5

# Fig. 6